(19) Europäisches Patentamt
European Patent Office
Office européen des brevets

(11) **EP 4 254 271 A1**

(12) **EUROPEAN PATENT APPLICATION**

(43) Date of publication:
**04.10.2023 Bulletin 2023/40**

(21) Application number: **22216933.6**

(22) Date of filing: **28.12.2022**

(51) International Patent Classification (IPC):
**G06N 3/044** (2023.01)    **G06N 5/01** (2023.01)

(52) Cooperative Patent Classification (CPC):
**G06N 5/01; G06N 3/044**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2022 JP 2022058462**

(71) Applicant: **FUJITSU LIMITED**
**Kawasaki-shi, Kanagawa 211-8588 (JP)**

(72) Inventors:
• **YIN, Fang**
  **Kawasaki-shi, Kanagawa, 211-8588 (JP)**
• **TAMURA, Hirotaka**
  **Yokohama-shi, Kanagawa, 223-0066 (JP)**

(74) Representative: **Hoffmann Eitle**
**Patent- und Rechtsanwälte PartmbB**
**Arabellastraße 30**
**81925 München (DE)**

(54) **DATA PROCESSING APPARATUS, PROGRAM, AND DATA PROCESSING METHOD**

(57)    A data processing apparatus configured to search for a combination of values of a plurality of state variables that minimizes or maximizes a value of an Ising-type evaluation function, when a change in a value of a first state variable is permitted, updating the value of the first state variable, updating a first local field based on a first weight value related to the first state variable, and updating a second local field based on a second weight value related to the first state variable, when the change in a value of the first auxiliary variable is permitted, updating the value of the first auxiliary variable, and updating the first local field based on a second weight value related to the first auxiliary variable.

FIG. 1

EP 4 254 271 A1

**Description**

FIELD

The embodiments discussed herein are related to a data processing apparatus, a program, and a data processing method.

BACKGROUND

There is an Ising device (also called a Boltzmann machine) that uses an Ising-type evaluation function (also called an energy function or the like) as a device that calculates a large-scale discrete optimization problem which Neumann computers are not good at.

The Ising device transforms the discrete optimization problem into an Ising model that represents spin behavior of a magnetic material. Then, the Ising device searches for a state of the Ising model where a value (corresponding to energy) of the Ising-type evaluation function is minimized by a Markov chain Monte Carlo method such as a simulated annealing method, a replica exchange method (also called a parallel tempering method), or the like. The state where a minimum value of local minimum values of the evaluation function is reached is to be an optimum solution. Note that the Ising device may search for a state where the value of the evaluation function is maximized by changing a sign of the evaluation function. A state of the Ising model may be represented by a combination of values of a plurality of state variables. As a value of each of the state variables, 0 or 1 may be used.

The Ising-type evaluation function is defined by, for example, a function in a quadratic form such as the following Expression (1).

[Expression 1]

$$E(x) = -\sum_{i=1}^{N}\sum_{j>i}^{N} W_{ij} x_i x_j - \sum_{i=1}^{N} b_i x_i \qquad (1)$$

A first term on a right side is obtained by integrating products of values (0 or 1) of two state variables and a weight value (representing strength of correlation between the two state variables) for all combinations of N state variables of the Ising model with neither an omission nor an overlap. A state variable with an identification number i is represented by $x_i$, a state variable with an identification number j is represented by $x_j$, and a weight value indicating magnitude of correlation between the state variables with the identification numbers i and j is represented by $W_{ij}$. A second term on the right side is obtained by summing up products of a bias coefficient and a state variable for each identification number. A bias coefficient for the identification number = i is represented by $b_i$.

Furthermore, an energy change amount ($\Delta E_i$) associated with a change in the value of $x_i$ is represented by the following Expression (2).

[Expression 2]

$$\Delta E_i = -\Delta x_i \left(\sum_{j}^{N} W_{ij} x_j + b_i\right) = -\Delta x_i h_i \qquad (2)$$

In Expression (2), when $x_i$ changes from 1 to 0, $\Delta x_i$ becomes -1, and when the state variable $x_i$ changes from 0 to 1, $\Delta x_i$ becomes 1. Note that $h_i$ is called a local field, and $\Delta E_i$ is obtained by multiplying $h_i$ by a sign (+1 or -1) according to $\Delta x_i$. Thus, $h_i$ may also be said to be a variable that represents the energy change amount, or a variable that determines the energy change amount.

Then, for example, processing of updating the value of $x_i$ with an acceptance probability that may be represented as $\exp(-\beta\Delta E_i)$ ($\beta$ is a reciprocal of a parameter representing temperature) to generate a state transition, and also updating the local field is repeated.

Incidentally, some discrete optimization problems have a constraint condition that needs to be satisfied by a solution. For example, a knapsack problem, which is one of the discrete optimization problems, has a constraint condition that a total capacity of luggage that may be packed in a knapsack is equal to or smaller than a capacity of the knapsack. Such a constraint condition is called an inequality constraint, and may be represented by a constraint term having a value depending on whether or not the constraint condition is violated. The constraint conditions include not only the inequality constraint but also an equality constraint, an absolute value constraint, and the like.

Total energy (H(x)) including the constraint term may be represented by the following Expression (3).
[Expression 3]

$$H(x) = -\frac{1}{2}\sum_{i \in D}\sum_{j \in D} W_{ij}x_i x_j - \sum_{i \in D} b_i x_i + \sum_{k \in A} \lambda_k g(h_k) \qquad (3)$$

In Expression (3), the sum of a first term and a second term on a right side represents energy corresponding to E(x) in Expression (1), and a third term on the right side represents overall magnitude (energy) of the constraint term. Furthermore, D represents a set of identification numbers of the state variables, k represents an identification number of the constraint term, and A represents a set of identification numbers of the constraint terms. Furthermore, $\lambda_k$ is a predetermined positive coefficient for the constraint term with the identification number k.

In a case where the constraint condition is the inequality constraint, $g(h_k)$ in Expression (3) may be represented by the following Expression (4).
[Expression 4]

$$g(h_k) = max[0, h_k], h_k = R_k - U_k = \sum_{i \in D} W_{ki}x_i - U_k \qquad (4)$$

In Expression (4), $max[0, h_k]$ is a function that outputs the larger value of 0 and $h_k$. Furthermore, $R_k$ represents a consumption amount (also called resource amount) of the constraint term with the identification number k, and $U_k$ represents an upper limit of the resource amount. $W_{ki}$ is a coefficient (weight value) indicating a weight of $x_i$ in the inequality constraint with the identification number k.

In Expression (3), an energy change amount ($\Delta H_j$) associated with a change in the value of $x_j$ is represented by the following Expression (5).
[Expression 5]

$$\Delta H_j = -h_j \Delta x_j + \sum_{k \in A} \lambda_k (g(h_k + W_{kj}\Delta x_j) - g(h_k)) \qquad (5)$$

In the case where the constraint condition is the inequality constraint, the energy change amount ($\Delta H_j$) associated with the change in the value of $x_j$ may be represented by the following Expression (6) instead of Expression (5).
[Expression 6]

$$\Delta H_j = -h_j \Delta x_j$$
$$+ \sum_{i=1}^{M} \lambda_i (max[0, h_i + a_{ij}\Delta x_j - C_{ui}] - max[0, h_i - C_{ui}])$$

In Expression (6), $a_{ij}$ is a coefficient indicating a weight of $x_j$ in the inequality constraint with the identification number i, and corresponds to $W_{ki}$ described above. $C_{ui}$ is an upper limit value in the inequality constraint with the identification number i, and corresponds to $U_k$ described above. M represents the number of constraint terms.

The acceptance probability of accepting a change in the value of $x_j$ may be represented as $A_j = min[1, exp(-\beta\Delta H_j)]$. A function that outputs the smaller value of 1 and $exp(-(\beta\Delta H_j))$ is represented by $min[1, exp(-(\beta\Delta H_j))]$.

Expression (3) is not a function in a quadratic form like Expression (1), but a discontinuous function in a linear form. Since before, there has been proposed a technology for transforming a discontinuous function in a linear form into a quadratic form so that an Ising device may handle an inequality constraint. However, in the case of calculating a discrete optimization problem by using a constraint term of the inequality constraint transformed into the quadratic form, it is sometimes difficult to solve the problem with the Ising device because processing becomes complicated, for example.

Thus, since before, there has been proposed a technology for solving a problem with an Ising device by using the constraint term of the inequality constraint as described above as it is in the linear form.

Japanese Laid-open Patent Publication No. 2020-201598 and Japanese Laid-open Patent Publication No. 2020-204928 are disclosed as related art.

SUMMARY

[TECHNICAL PROBLEM]

In the known technology for solving a problem by using the constraint term of the inequality constraint as it is in the linear form, calculation using all coefficients related to each constraint term ($a_{ij}$ in the example of Expression (6) described above) is performed when calculation of $\Delta H_j$ associated with a change in a value of a state variable is performed.

There may be equal to or greater than 1000 coefficients related to each constraint term. In the known technology, when the calculation of $\Delta H_j$ is performed, all the coefficients are read from a memory to perform addition processing. Thus, overhead of a calculation time may become large.

In one aspect, an embodiment aims to provide a data processing apparatus, a program, and a data processing method capable of reducing overhead of a calculation time for a discrete optimization problem with a constraint condition.

[SOLUTION TO PROBLEM]

According to an aspect of the embodiments, a data processing apparatus that searches for a combination of values of a plurality of state variables that minimizes or maximizes a value of an Ising-type evaluation function that includes the plurality of state variables, the data processing apparatus includes a storage unit that store total energy that is a sum of values of a plurality of constraint terms and the value of the evaluation function, the values of the plurality of state variables, values of a plurality of auxiliary variables, a first weight value between each of the plurality of state variables, a second weight value between one of the plurality of state variables and each of the plurality of auxiliary variables, a first local field, and a second local field, the plurality of constraint terms including values that correspond to whether each of a plurality of constraint conditions is violated, plurality of auxiliary variables indicating whether each of the plurality of constraint conditions is violated, the first local field indicating a change amount of the total energy when a value of each of the plurality of state variables changes, the second local field being a value proportional to a change amount of the total energy when a value of each of the plurality of auxiliary variables changes; a processing unit that: performs first processing that includes: determining whether to permit a change in a value of a first state variable among the plurality of state variables based on the first local field, and when the change in the value of the first state variable is permitted, updating the value of the first state variable, updating the first local field based on the first weight value related to the first state variable, and updating the second local field based on the second weight value related to the first state variable, and performs second processing that includes: determining whether to permit a change in a value of a first auxiliary variable among the plurality of auxiliary variables based on the second local field, and when the change in the value of the first auxiliary variable is permitted, updating the value of the first auxiliary variable, and updating the first local field based on the second weight value related to the first auxiliary variable.

[ADVANTAGEOUS EFFECTS OF INVENTION]

In one aspect, an embodiment may reduce overhead of a calculation time for a discrete optimization problem with a constraint condition.

BRIEF DESCRIPTION OF DRAWINGS

FIG. 1 is a diagram illustrating an example of a data processing apparatus and a data processing method of a first embodiment;
FIG. 2 is a diagram illustrating an example of correlation between state variables and auxiliary variables;
FIG. 3 is a diagram illustrating an example of error correction;
FIG. 4 is a diagram illustrating a data processing apparatus of a comparative example;
FIG. 5 is a block diagram illustrating a hardware example of a data processing apparatus of a second embodiment;
FIG. 6 is a block diagram illustrating a functional example of the data processing apparatus;
FIG. 7 is a diagram illustrating an example of local field update processing;
FIG. 8 is a flowchart illustrating a flow of a first example of a data processing method;
FIG. 9 is a flowchart illustrating a flow of a second example of the data processing method;
FIG. 10 is a diagram illustrating another example of the data processing apparatus; and
FIG. 11 is a diagram illustrating an example using four values of auxiliary variables.

DESCRIPTION OF EMBODIMENTS

Hereinafter, modes for carrying out embodiments will be described with reference to the drawings.

(First Embodiment)

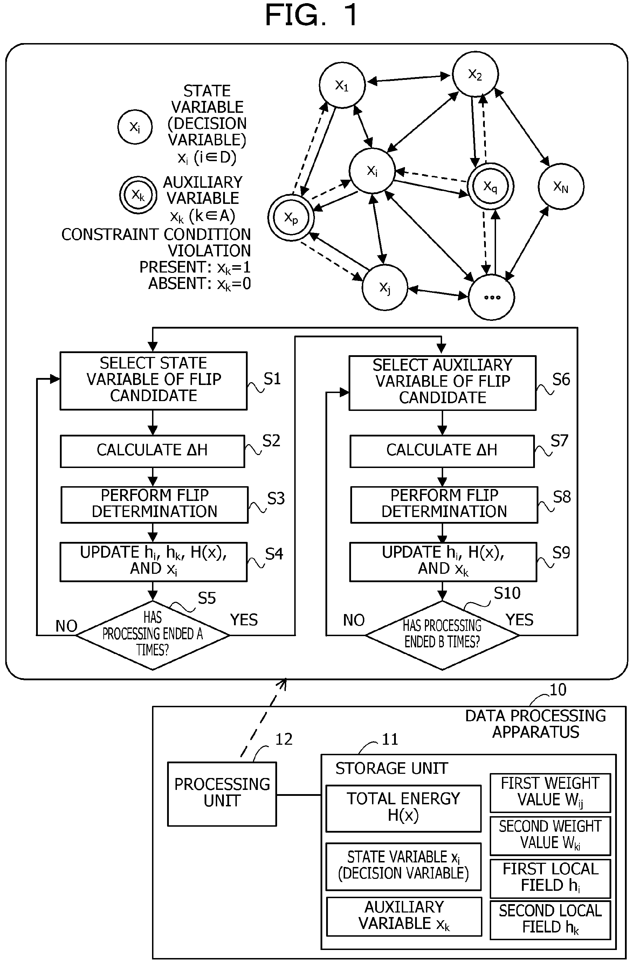

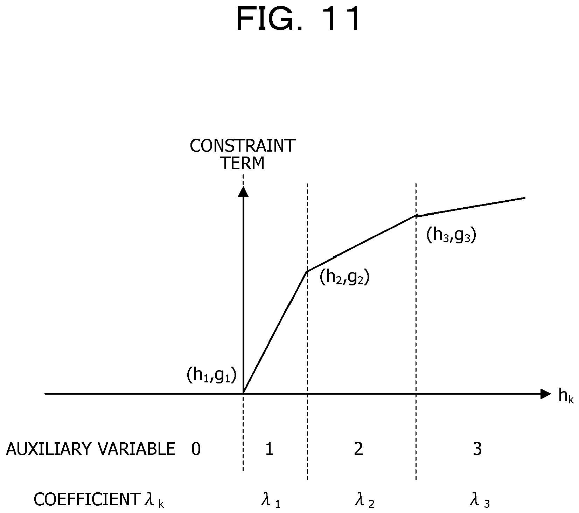

FIG. 1 is a diagram illustrating an example of a data processing apparatus and a data processing method of a first embodiment.
A data processing apparatus 10 of the first embodiment includes a storage unit 11 and a processing unit 12.
The storage unit 11 is, for example, a volatile storage device that is an electronic circuit such as a dynamic random access memory (DRAM), or a non-volatile storage device that is an electronic circuit such as a hard disk drive (HDD) or a flash memory. The storage unit 11 may include an electronic circuit such as a register.
The storage unit 11 stores H(x), a plurality of (hereinafter N) values of state variables $(x_i)$, a plurality of (hereinafter M) values of auxiliary variables $(x_k)$, a first weight value ($W_{ij}$ described above) between each of the N $x_i$'s, and a second weight value ($W_{ki}$) between any one of the N $x_i$'s and each of the M $x_k$'s.
An identification number representing any one of the N $x_i$'s is represented by i, and an identification number representing any one of the M $x_k$'s or any one of M constraint terms (or M constraint conditions) is represented by k.
The M $x_k$'s represent whether or not each of the M constraint conditions is violated. In the following description, description will be made assuming that $x_k$ has a value of 1 in the case of violating a constraint condition with the identification number = k and has a value of 0 in the case of satisfying the constraint condition, but the present disclosure is not limited to this. A spin variable having a value of -1 or +1 may also be used as $x_k$. Furthermore, the auxiliary variable may have a plurality of values other than 0 in the case of a constraint condition violation (see FIG. 11).
Moreover, the storage unit 11 stores a first local field $(h_i)$ that represents a change amount of H(x) in a case where each of the values of the N $x_i$'s changes, and a second local field $(h_k)$ that is a value proportional to a change amount of H(x) in a case where each of the values of the M $x_k$'s changes. Note that the state variable may also be called a decision variable.
Total energy P(x) of the M constraint terms corresponding to M inequality constraints may be represented by the following Expression (7).
[Expression 7]

$$P(x) = \sum_{k \in A} \lambda_k max[0, R_k(x) - U_k] \qquad (7)$$

$\lambda_k$ is a proportional coefficient related to a constraint term with the identification number = k and represents a weight of the constraint term. $\lambda_k$ may be a different value for each constraint term. $U_k$ represents an upper limit that a resource amount ($R_k(x)$) needs to satisfy in the inequality constraint. $R_k(x)$ may be represented by the following Expression (8).
[Expression 8]

$$R_k(x) = \sum_{i \in D, k \in A} W_{ki} x_i \qquad (8)$$

H(x) represented by Expression (3) and Expression (4) may be represented by the following Expression (9) by using the auxiliary variable $(x_k)$.
[Expression 9]

$$H(x) = E(x) + P(x) \qquad (9)$$
$$= E(x) + \sum_{k \in A} \lambda_k \left( \sum_{i \in D} W_{ki} x_i - U_k \right) x_k$$

The M $x_k$'s are used corresponding to the number of M inequality constraints. In the following example, it is assumed that $x_k$ is represented by the following Expression (10).
[Expression 10]

$$x_k = \begin{cases} 0 & for & \sum_{i \in D} W_{ki}x_i - U_k < 0 \\ 1 & for & \sum_{i \in D} W_{ki}x_i - U_k \geq 0 \end{cases} \tag{10}$$

In FIG. 1, an example of a neural network in a case where each of the state variables (decision variables) and the auxiliary variables is regarded as a neuron is illustrated. The neural network has a configuration in which the neurons by the auxiliary variables that detect a constraint condition violation are added to a neural network of a Boltzmann machine by the state variables.

In the example of FIG. 1, a neuron representing an auxiliary variable $x_p$ is connected to neurons representing state variables $x_1$, $x_i$, and $x_j$. For example, the second weight value between $x_p$ and each of $x_1$, $x_i$, and $x_j$ has a value other than 0. A neuron representing an auxiliary variable $x_q$ is connected to neurons representing a state variable $x_2$, the state variable $x_i$, and the like. Since not all state variables often affect each inequality constraint, it is sufficient that the second weight value is stored for a state variable that affects each inequality constraint.

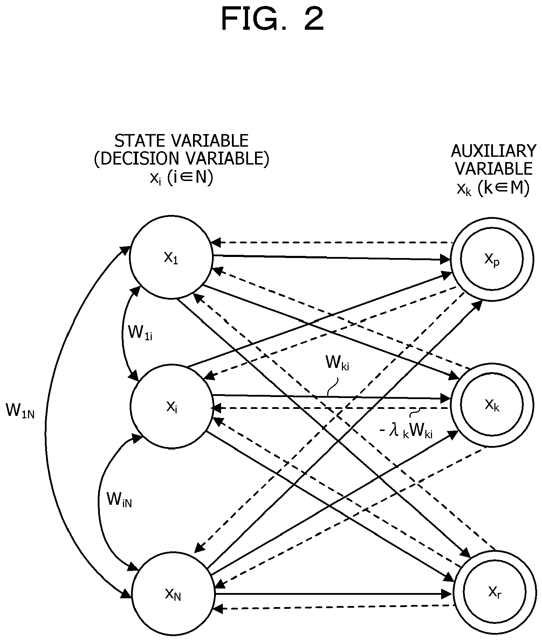

FIG. 2 is a diagram illustrating an example of correlation between the state variables and the auxiliary variables.

Strength of correlation between the N state variables may be represented by $N \times N$ $W_{ij}$'s. For example, strength of correlation between $x_1$ and $x_i$ is $W_{1i}$, strength of correlation between $x_i$ and $x_N$ is $W_{iN}$, and strength of correlation between $x_1$ and $x_N$ is $W_{1N}$. On the other hand, in the correlation between the state variables and the auxiliary variables, an influence of changes in values of the state variables on the auxiliary variables is different from an influence of changes in the auxiliary variables on the state variables. For example, as illustrated in FIG. 2, an influence of a change in the value of the state variable $x_i$ on the auxiliary variable $x_k$ may be represented by the weight value $W_{ki}$, and an influence of a change in a value of the auxiliary variable $x_k$ on the state variable $x_i$ may be represented by $-\lambda_k W_{ki}$.

The N first local fields ($h_i$) stored in the storage unit 11 illustrated in FIG. 1 may be represented by the following Expression (11).

[Expression 11]

$$h_i = \sum_{j \in D} W_{ij}x_j + b_i - \sum_{k \in A} \lambda_k W_{ki}x_k \tag{11}$$

The M second local fields ($h_k$) stored in the storage unit 11 may be represented by the following Expression (12).

[Expression 12]

$$h_k = \sum_{i \in D, k \in A} W_{ki}x_i - U_k \tag{12}$$

The storage unit 11 may further store a bias coefficient ($b_i$), the proportional coefficient ($\lambda_k$), and the upper limit ($U_k$). Furthermore, the storage unit 11 may store various types of data such as calculation conditions when the processing unit 12 executes the data processing method to be described later. Furthermore, in a case where the processing unit 12 executes a part or all of processing of the data processing method to be described later by software, the storage unit 11 stores a program for executing the processing.

The processing unit 12 of FIG. 1 may be implemented by, for example, a processor that is hardware such as a central processing unit (CPU), a graphics processing unit (GPU), or a digital signal processor (DSP). Furthermore, the processing unit 12 may be implemented by an electronic circuit such as an application specific integrated circuit (ASIC) or a field programmable gate array (FPGA).

For example, the processing unit 12 searches for a state where a value (energy) of the evaluation function indicated in Expression (1) is minimized. The state where a minimum value of local minimum values of the evaluation function is reached is to be an optimum solution. Note that the processing unit 12 may also search for a state where the value of the evaluation function is maximized by changing the signs of the evaluation function indicated in Expression (1) and the constraint term indicated in Expression (7) (in this case, the state where the maximum value is reached is to be the optimum solution).

In FIG. 1, a flow of an example of processing by the processing unit 12 is illustrated.

Note that, here, it is assumed that values based on initial values of $x_1$ to $x_N$ are stored in the storage unit 11 as H(x), $h_i$, $h_k$, and $x_k$.

Steps S1 to S5 are processing related to the state variables, and Steps S6 to S10 are processing related to the auxiliary variables.

The processing unit 12 selects a state variable of a candidate (hereinafter referred to as a flip candidate) whose value is to be changed from the N state variables (Step S1). The processing unit 12 selects the state variable of the flip candidate at random or in a predetermined order, for example.

Then, the processing unit 12 calculates $\Delta H$ in a case where a value of the selected state variable changes (Step S2). For example, in a case where $x_i$ is selected, $\Delta H$ may be calculated by an expression $\Delta H = -h_i \Delta x_i$ based on $h_i$ indicated in Expression (11).

Next, the processing unit 12 determines whether or not to permit a change in the value of the state variable of the flip candidate (whether or not flip is permissible) based on a result of comparison between $\Delta H$ and a predetermined value (Step S3). Hereinafter, this determination processing will be referred to as flip determination processing.

The predetermined value is, for example, a noise value obtained based on a random number and a value of a temperature parameter. For example, $\log(\text{rand}) \times T$, which is an example of a noise value obtained based on a uniform random number (rand) equal to or greater than 0 and equal to or smaller than 1 and a temperature parameter ($T$), may be used as the predetermined value. In this case, in a case where $-\Delta H_i \geq \log(\text{rand}) \times T$, the processing unit 12 determines that the change in the value of the state variable of the flip candidate is permitted (flip is permissible).

In a case where it is determined that flip is permissible, the processing unit 12 updates $h_i$, $h_k$, $H(x)$, and $x_i$ (state variables for which it is determined that flip is permissible) (Step S4). Note that the processing unit 12 does not update $h_i$, $h_k$, $H(x)$, and $x_i$ unless it is determined that flip is permissible.

The processing unit 12 updates $H(x)$ by adding $\Delta H$ to the original $H(x)$. Furthermore, for example, in a case where it is determined that flip is permissible for $x_j$, the processing unit 12 updates $h_i$ by adding $\Delta h_i = W_{ij} \Delta x_j$ to the original $h_i$ for each of the N state variables. Moreover, in a case where it is determined that flip is permissible for $x_j$, the processing unit 12 updates $h_k$ by adding $\Delta h_k = W_{kj} \Delta x_j$ to the original $h_k$ for each of the M state variables. In a case where a violation of the constraint condition of the identification number = k occurs in a case where the value of $x_j$ is changed, $h_k$ becomes a positive value by this update, and a change in $x_k$ from 0 to 1 is permitted by processing of Step S8 to be described later.

Thereafter, the processing unit 12 determines whether or not the processing as described above has been performed A times (Step S5). A is an integer equal to or greater than 1. In a case where it is determined that the processing as described above has not been performed A times, the processing unit 12 repeats the processing from Step S1.

In a case where it is determined that the processing as described above has been performed A times, the processing unit 12 selects an auxiliary variable of a flip candidate from the M auxiliary variables (Step S6). The processing unit 12 selects the auxiliary variable of the flip candidate at random or in a predetermined order, for example.

Then, the processing unit 12 calculates $\Delta H$ in a case where a value of the selected auxiliary variable changes (Step S7). For example, in a case where $x_k$ is selected, $\Delta H$ may be calculated by an expression $\Delta H = +\lambda_k h_k \Delta x_k$ by using $h_k$ indicated in Expression (12).

Next, the processing unit 12 determines whether or not to permit a change in the value of the auxiliary variable of the flip candidate (whether or not flip is permissible) based on a result of comparison between $\Delta H$ and a predetermined value (flip determination processing) (Step S8).

The predetermined value may be the same as the value used in the processing of Step S3, or may be a fixed value (for example, 0). In a case where $\log(\text{rand}) \times T$ is used as the predetermined value and in a case where $\Delta H > \log(\text{rand}) \times T$, the processing unit 12 determines that flip is permissible for the auxiliary variable of the flip candidate. In a case where a violation of the constraint occurs due to the change in the value of the state variable by the processing of Step S4, $h_k$ in Expression (12) becomes a positive value, and a change amount $\Delta x_k = 1$ in a case where $x_k$ changes from 0 to 1. Thus, $\Delta H$ is a positive value. Furthermore, $\log(\text{rand}) \times T$ is a negative value. Thus, $x_k$ is permitted to change from 0 to 1 by using the determination expression $\Delta H > \log(\text{rand}) \times T$.

In a case where it is determined that flip is permissible for $x_k$ of the flip candidate, the processing unit 12 updates $h_i$, $H(x)$, and $x_k$ (auxiliary variables for which it is determined that flip is permissible) (Step S9). Note that the processing unit 12 does not update $h_i$, $H(x)$, and $x_k$ unless it is determined that flip is permissible.

The processing unit 12 updates $H(x)$ by adding $\Delta H$ to the original $H(x)$. Furthermore, for example, in a case where it is determined that the flip is permissible for $x_k$, the processing unit 12 updates $h_i$ by adding $\Delta h_i = -\lambda_k W_{ki} \Delta x_k$ to the original $h_i$ for each of the N state variables.

Thereafter, the processing unit 12 determines whether or not the processing as described above has been performed B times (Step S10). B is an integer equal to or greater than 1. In a case where it is determined that the processing as described above has not been performed B times, the processing unit 12 repeats the processing from Step S6.

In a case where it is determined that the processing as described above has been performed B times, the processing unit 12 repeats the processing from Step S1 again.

In the processing of Step S2 described above, since $\Delta H$ is calculated without changing the value of the auxiliary variable, an error may occur depending on whether or not the value of the auxiliary variable changes, but the error may be corrected by $\Delta H = +\lambda_k h_k \Delta x_k$ obtained by the processing of Step S7.

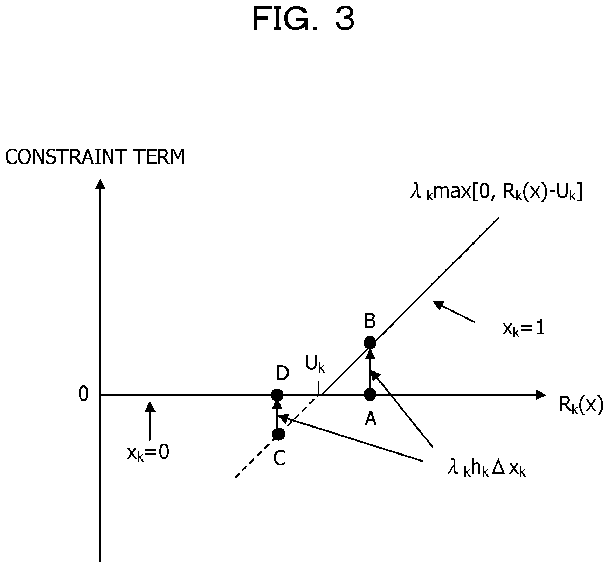

FIG. 3 is a diagram illustrating an example of error correction. A vertical axis represents magnitude of the constraint term with the identification number k, and a horizontal axis represents $R_k(x)$ (resource amount) represented by Expression (8) described above.

Since the inequality constraint is satisfied until $R_k(x)$ exceeds $U_k$, the magnitude of the constraint term is also 0. On the other hand, when $R_k(x)$ exceeds $U_k$, the constraint term increases according to an expression $\lambda_k \max[0, R_k(x) - U_k]$. Note that, since $\Delta H$ is calculated without changing the value of the auxiliary variable in the processing of Step S2 as described above, an error may occur in $\Delta H$ at that time.

For example, at a point A in FIG. 3, even though $R_k(x)$ exceeds $U_k$ (a constraint condition violation occurs), $x_k$ = 0, which means that the magnitude of the constraint term is 0 and an error of $\lambda_k h_k \Delta x_k$ occurs. Thus, the processing unit 12 permits a change in the value of $x_k$ (change from 0 to 1), and uses $\Delta H = +\lambda_k h_k \Delta x_k$ obtained by the processing of Step S7 to correct the constraint term to appropriate magnitude (magnitude of a point B).

Furthermore, for example, at a point C in FIG. 3, even though $R_k(x)$ is equal to or smaller than $U_k$ (a constraint condition violation is resolved), $x_k$ = 1, which means that the magnitude of the constraint term is not 0 and an error of $\lambda_k h_k \Delta x_k$ occurs. Thus, the processing unit 12 permits a change in the value of $x_k$ (change from 1 to 0), and uses $\Delta H = +\lambda_k h_k \Delta x_k$ obtained by the processing of Step S7 to correct the constraint term to appropriate magnitude (magnitude of a point D).

Note that an order of the processing illustrated in FIG. 1 is an example, and the order of the processing may be appropriately changed.

Furthermore, in the description above, an example is indicated in which one state variable of the flip candidate is selected from among the N state variables and the processing of Steps S2 and S3 is performed. However, the processing of Steps S2 and S3 may be performed in parallel for a plurality of (for example, all the N) state variables. In that case, when there is a plurality of state variables whose values are permitted to change, the processing unit 12 selects a state variable whose value is to be changed at random or according to a predetermined rule.

Similarly, in the description above, an example is indicated in which one auxiliary variable of the flip candidate is selected from among the M state variables, and the processing of Steps S7 and S8 is performed. However, the processing of Steps S7 and S8 may be performed in parallel for a plurality of (for example, all the M) state variables. In that case, when there is a plurality of auxiliary variables whose values are permitted to change, the processing unit 12 selects an auxiliary variable whose value is to be changed at random or according to a predetermined rule.

In a case where a simulated annealing method is performed, for example, the processing unit 12 reduces a value of the temperature parameter (T) described above according to a predetermined temperature parameter change schedule each time when flip determination processing for a state variable is repeated a predetermined number of times. Then, the processing unit 12 outputs a state obtained in a case where the flip determination processing is repeated the predetermined number of times as a calculation result of a discrete optimization problem (for example, displays on a display device (not illustrated)). Note that the processing unit 12 may cause the storage unit 11 to hold total energy and a state in a case where the energy becomes the minimum until then. In that case, the processing unit 12 may output a state corresponding to the minimum energy stored after the flip determination processing is repeated the predetermined number of times as a calculation result.

In a case where the processing unit 12 performs a replica exchange method, the processing unit 12 repeats the processing of Steps S1 to S10 described above for each of a plurality of replicas to which each different T value is set. Then, the processing unit 12 exchanges the replica each time when the flip determination processing is repeated the predetermined number of times. For example, the processing unit 12 selects two replicas having adjacent T values and exchanges the values of the respective state variables and the values of the respective auxiliary variables between the selected two replicas at a predetermined exchange probability based on an energy difference or a T value difference between the replicas. Note that the T values may be exchanged between the two replicas instead of the values of the respective state variables and the values of the respective auxiliary variables. Alternatively, the processing unit 12 holds the total energy and the state in a case where the energy becomes the minimum until then. Then, the processing unit 12 outputs, as a calculation result, a state corresponding to the minimum energy in all the replicas, among the minimum energy stored after the flip determination processing described above is repeated the predetermined number of times in each replica.

By using the replica exchange method, the state changes even on a low temperature side (replica on a side where the T value is small) where the state hardly changes, and possibility of finding a good solution in a short time increases.

According to the data processing apparatus 10 and the data processing method as described above, in a case where the value of the auxiliary variable ($x_k$) representing whether or not a certain constraint condition is violated is permitted to change, $h_i$ is updated based on the N $W_{ki}$'s. With this configuration, $W_{ki}$'s related to all the M constraint terms do not have to be read, and the number of times the addition processing (processing of adding $\Delta h_i = -\lambda_k W_{ki} \Delta x_k$ to the original $h_i$) is performed is suppressed, and overhead of a calculation time for update processing may be reduced.

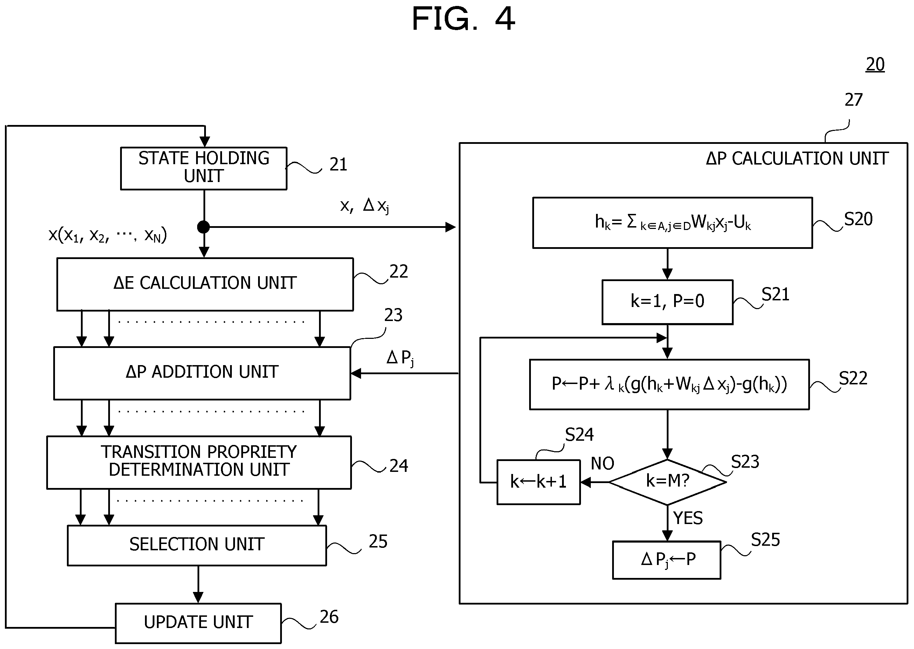

FIG. 4 is a diagram illustrating a data processing apparatus of a comparative example.

A data processing apparatus 20 of the comparative example performs, as in the known technology, calculation using all coefficients related to each constraint term ($W_{kj}$ in the example of Expression (5) and $a_{ij}$ in the example of Expression (6) described above) when performing calculation of $\Delta H_j$ associated with a change in a value of a state variable.

The data processing apparatus 20 of the comparative example includes a state holding unit 21, a $\Delta E$ calculation unit 22, a $\Delta P$ addition unit 23, a transition propriety determination unit 24, a selection unit 25, an update unit 26, and a $\Delta P$ calculation unit 27.

The state holding unit 21 holds a state x ($x_1$ to $x_N$) and outputs x. Furthermore, the state holding unit 21 outputs $\Delta x_j$.

The $\Delta E$ calculation unit 22 calculates $\Delta E_j$ (first term on a right side of Expression (5)) in a case where each of $x_1$ to $x_N$ changes.

The $\Delta P$ addition unit 23 adds $\Delta P_j$ (second term on the right side of Expression (5)) to $\Delta E_j$. With this configuration, $\Delta H_j$ in Expression (5) is calculated.

The transition propriety determination unit 24 performs flip determination processing for each of $x_1$ to $x_N$ based on a result of comparison between $\Delta H_j$ and the predetermined value described above.

The selection unit 25 selects, in a case where there is a plurality of state variables for which it is determined that flip is permissible, any one of the state variables.

The update unit 26 sends an identification number of a state variable for which it is determined that flip is permissible to the state holding unit 21 to change a value of the state variable. Furthermore, the update unit 26 updates $h_j$ and H.

The $\Delta P$ calculation unit 27 calculates $\Delta P_j$ in a case where each of $x_1$ to $x_N$ changes. The calculation of $\Delta P_j$ is performed as follows, for example.

The $\Delta P$ calculation unit 27 calculates $h_k$ (Step S20). In the example of FIG. 4, $h_k$ is calculated using j instead of i in Expression (4).

Next, the $\Delta P$ calculation unit 27 sets k = 1 and P = 0 (Step S21), and newly sets P as a result of calculating P + $\lambda_k(g(h_k + W_{kj}\Delta x_j) - g(h_k))$ based on the second term on the right side of Expression (5) (Step S22).

Then, the $\Delta P$ calculation unit 27 determines whether or not k = M holds (Step S23). In a case where it is determined that k = M does not hold, the $\Delta P$ calculation unit 27 sets k to k + 1 (Step S24), and repeats the processing from Step S22.

In a case where it is determined that k = M holds, the $\Delta P$ calculation unit 27 outputs P as $\Delta P_j$.

In the processing as described above, the processing of Step S22 is repeated M times to calculate $\Delta P_j$ for each of $x_1$ to $x_N$. For example, reading of $W_{kj}$ and addition processing are performed M times. Thus, it takes a time proportional to N × M to calculate N $\Delta P_j$'s, and overhead of a calculation time is large. Furthermore, a data transfer amount for the reading is large. This is because the M $W_{kj}$'s are serially read in calculating one $\Delta P_j$.

On the other hand, in the data processing apparatus 10 of the first embodiment, since $h_i$ is updated by $\Delta h_i = -\lambda_k W_{ki}\Delta x_k$ for the auxiliary variable whose value is permitted to change among the M auxiliary variables, it is sufficient that the N $W_{ki}$'s are read once. With this configuration, overhead of the calculation time may be reduced, and the data transfer amount for reading $W_{ki}$ may also be reduced.

(Second Embodiment)

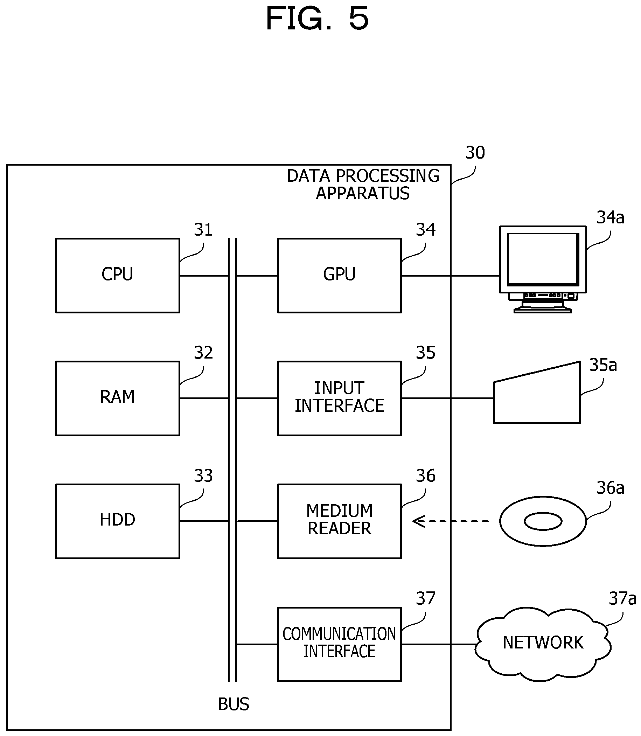

FIG. 5 is a block diagram illustrating a hardware example of a data processing apparatus of a second embodiment.

A data processing apparatus 30 is, for example, a computer, and includes a CPU 31, a random access memory (RAM) 32, an HDD 33, a GPU 34, an input interface 35, a medium reader 36, and a communication interface 37. The units described above are connected to a bus.

The CPU 31 is a processor including an arithmetic circuit that executes a command of a program. The CPU 31 loads at least a part of a program and data stored in the HDD 33 into the RAM 32 to execute the program. Note that the CPU 31 may include a plurality of processor cores, the data processing apparatus 30 may include a plurality of processors, and processing to be described below may be executed in parallel by using the plurality of processors or processor cores. Furthermore, a set of a plurality of processors (multiprocessor) may be called a "processor".

The RAM 32 is a volatile semiconductor memory temporarily storing a program executed by the CPU 31 and data used by the CPU 31 for arithmetic operations. Note that the data processing apparatus 30 may include a memory of a type other than the RAM 32, or may include a plurality of memories.

The HDD 33 is a non-volatile storage device storing programs for software such as an operating system (OS), middleware, or application software, and data. The programs include, for example, a program for causing the data processing apparatus 30 to execute processing for searching for a solution to a discrete optimization problem. Note that the data processing apparatus 30 may include another type of storage device such as a flash memory or a solid state drive (SSD), or may include a plurality of non-volatile storage devices.

The GPU 34 outputs an image to a display 34a connected to the data processing apparatus 30 in accordance with a command from the CPU 31. As the display 34a, a cathode ray tube (CRT) display, a liquid crystal display (LCD), a plasma display panel (PDP), an organic electro-luminescence (OEL) display, or the like may be used.

The input interface 35 acquires an input signal from an input device 35a connected to the data processing apparatus 30, and outputs the input signal to the CPU 31. As the input device 35a, a pointing device such as a mouse, a touch panel, a touch pad, or a trackball, a keyboard, a remote controller, a button switch, or the like may be used. Furthermore, a plurality of types of input devices may be connected to the data processing apparatus 30.

The medium reader 36 is a reading device that reads a program and data recorded on a recording medium 36a. As the recording medium 36a, for example, a magnetic disk, an optical disk, a magneto-optical disk (MO), a semiconductor memory, or the like may be used. The magnetic disk includes a flexible disk (FD) and an HDD. The optical disk includes a compact disc (CD) and a digital versatile disc (DVD).

The medium reader 36 copies, for example, a program and data read from the recording medium 36a to another recording medium such as the RAM 32 or the HDD 33. The read program is executed by, for example, the CPU 31. Note that the recording medium 36a may be a portable recording medium, and may be used for distribution of a program and data. Furthermore, the recording medium 36a or the HDD 33 may be referred to as a computer-readable recording medium.

The communication interface 37 is an interface that is connected to a network 37a and communicates with another information processing device via the network 37a. The communication interface 37 may be a wired communication interface connected to a communication device such as a switch by a cable, or may be a wireless communication interface connected to a base station by a wireless link.

Next, functions and processing procedures of the data processing apparatus 30 will be described.

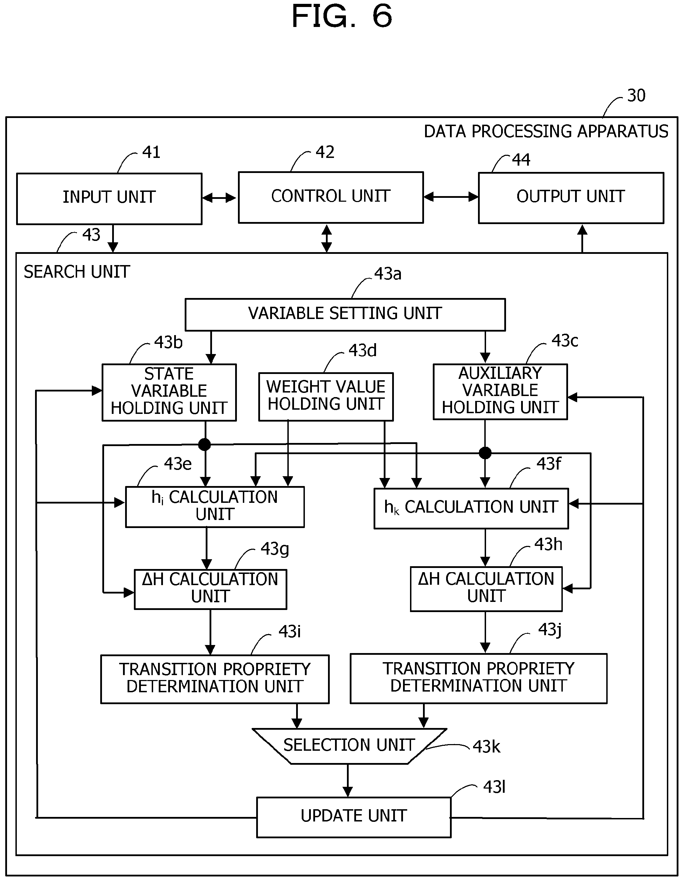

FIG. 6 is a block diagram illustrating a functional example of the data processing apparatus.

The data processing apparatus 30 includes an input unit 41, a control unit 42, a search unit 43, and an output unit 44.

The input unit 41, the control unit 42, the search unit 43, and the output unit 44 may be implemented by using, for example, a program module executed by the CPU 31 or a storage area (register or cache memory) in the CPU 31. Note that the search unit 43 may be further implemented by using a storage area secured in the RAM 32 or the HDD 33.

The input unit 41 receives, for example, input of initial values of N state variables, initial values of M auxiliary variables, problem information, and calculation conditions. The problem information includes, for example, $W_{ki}$, $U_k$, and $\lambda_k$ in Expression (9) in addition to $W_{ij}$ and $b_i$ in Expression (1). The calculation conditions include, for example, the number of replicas, a replica exchange cycle, and a value of a temperature parameter set for each replica in a case where the replica exchange method is executed, a temperature parameter change schedule in a case where the simulated annealing method is performed, calculation end conditions, and the like.

These pieces of information may be input by operation of the input device 35a by a user, or may be input via the recording medium 36a or the network 37a.

The control unit 42 controls each unit of the data processing apparatus 30 to execute processing to be described later.

The search unit 43 repeats flip determination processing and update processing under the control of the control unit 42, thereby searching for a state where a value (energy) of an evaluation function is minimized.

The output unit 44 outputs a search result (calculation result) by the search unit 43.

For example, the output unit 44 may output the calculation result to the display 34a to be displayed, transmit the calculation result to another information processing device via the network 37a, or store the calculation result in an external storage device.

The search unit 43 includes a variable setting unit 43a, a state variable holding unit 43b, an auxiliary variable holding unit 43c, a weight value holding unit 43d, an $h_i$ calculation unit 43e, an $h_k$ calculation unit 43f, $\Delta H$ calculation units 43g and 43h, and transition propriety determination units 43i and 43j, a selection unit 43k, and an update unit 43l.

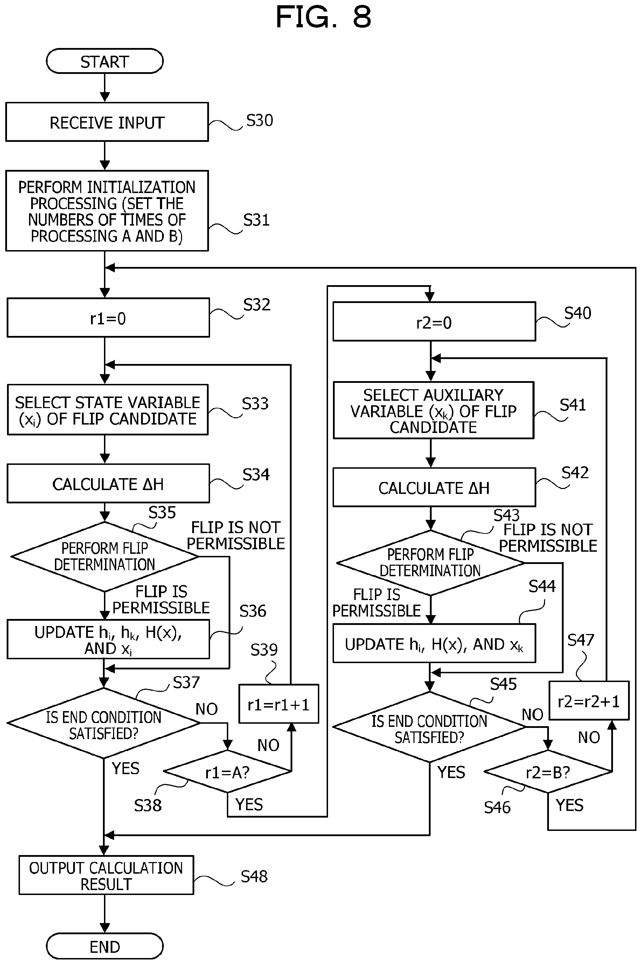

In the variable setting unit 43a, for example, an order of selecting state variables of flip candidates, an order of selecting auxiliary variables of flip candidates, and the numbers of times of state variable flip determination processing and auxiliary variable flip determination processing (corresponding to A times and B times in FIG. 8 to be described later) are set.

The state variable holding unit 43b holds N state variables ($x_i$). Furthermore, the state variable holding unit 43b outputs a change amount ($\Delta x_i$) of $x_i$ of a flip candidate.

The auxiliary variable holding unit 43c holds M auxiliary variables.

The weight value holding unit 43d holds weight values ($W_{ij}$) between the N state variables and weight values ($W_{ki}$) between each of the N state variables and the M auxiliary variables. $W_{ij}$ may be represented by a matrix of N rows and N columns, and $W_{ki}$ may be represented by a matrix of M rows and N columns.

Note that it is not needed to hold a weight value between state variables that do not affect any one of the M auxiliary variables among the N state variables and the M auxiliary variables. Hereinafter, a ratio of such state variables among the N state variables is referred to as a sparse ratio $\eta$.

The $h_i$ calculation unit 43e holds N $h_i$'s and updates the $h_i$'s according to changes in values of state variables and auxiliary variables.

The $h_k$ calculation unit 43f holds M $h_k$'s and updates the $h_k$'s according to changes in the values of the state variables.

The $\Delta H$ calculation unit 43g calculates $\Delta H = -h_i\Delta x_i$ based on $h_i$ for $x_i$ of a flip candidate.

The $\Delta H$ calculation unit 43h calculates $\Delta H = +\lambda_k h_k \Delta x_k$ based on $h_k$ for $x_k$ of a flip candidate.

The transition propriety determination unit 43i performs flip determination processing to determine whether or not to permit a change in a value of a state variable of a flip candidate based on a result of comparison between $\Delta H$ output by the $\Delta H$ calculation unit 43g and a predetermined value. The predetermined value is, for example, a noise value obtained based on a random number and a value of a temperature parameter. For example, in a case where $-\Delta H \geq \log(\text{rand}) \times T$, the transition propriety determination unit 43i determines that the change in the value of the state variable of the flip candidate is permitted.

The transition propriety determination unit 43j performs flip determination processing to determine whether or not to permit a change in a value of an auxiliary variable of a flip candidate based on a result of comparison between $\Delta H$ output by the $\Delta H$ calculation unit 43h and a predetermined value. The predetermined value may be the same as the value used by the transition propriety determination unit 43i, or may be a fixed value (for example, 0). For example, in a case where $\Delta H > \log(\text{rand}) \times T$, the transition propriety determination unit 43j determines that the change in the value of the auxiliary variable of the flip candidate is permitted.

The selection unit 43k selects a determination result of the transition propriety determination unit 43i in a case where flip determination processing for a state variable is performed, and selects a determination result of the transition propriety determination unit 43j in a case where flip determination processing for an auxiliary variable is performed, and outputs the determination result.

The update unit 43l sends an identification number of a state variable for which it is determined that flip is permissible to the state variable holding unit 43b to change a value of the state variable. Furthermore, the update unit 43l sends an identification number of an auxiliary variable for which it is determined that flip is permissible to the auxiliary variable holding unit 43c to change a value of the auxiliary variable.

Moreover, in a case where it is determined that flip is permissible for a state variable of a flip candidate, the update unit 43l causes the $h_i$ calculation unit 43e and the $h_k$ calculation unit 43f to update N $h_i$'s and M $h_k$'s. In a case where it is determined that flip is permissible for an auxiliary variable of a flip candidate, the update unit 43l causes the $h_i$ calculation unit 43e to update N $h_i$'s. Furthermore, the update unit 43l may hold H and update H based on $\Delta H$ generated by a change in a value of a state variable or an auxiliary variable for which it is determined that flip is permissible.

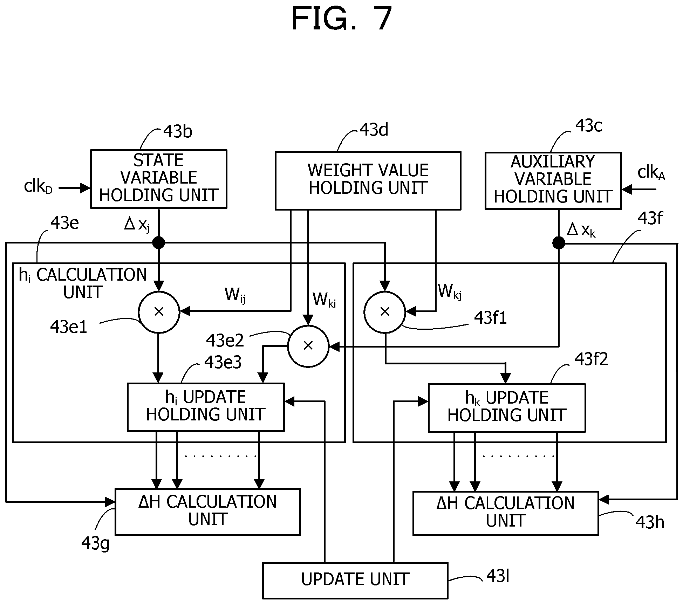

FIG. 7 is a diagram illustrating an example of local field update processing.

Note that, in the example of FIG. 7, description will be made assuming that a state variable of a flip candidate is $x_j$ and an auxiliary variable of a flip candidate is $x_k$. In this case, $\Delta x_j$ is output from the state variable holding unit 43b in synchronization with a clock signal $\text{clk}_D$ supplied from the control unit 42, and $\Delta x_k$ is output from the auxiliary variable holding unit 43c in synchronization with a clock signal $\text{clk}_A$ supplied from the control unit 42.

Furthermore, in a case where it is determined that flip is permissible for $x_j$, N $W_{ij}$'s, which are weight values between $x_j$ and each of the N state variables, and M $W_{kj}$'s, which are weight values between $x_j$ and each of the M auxiliary variables, are read from the weight value holding unit 43d. Furthermore, in a case where it is determined that flip is permissible for $x_k$, N $W_{ki}$'s, which are weight values between $x_k$ and each of the N state variables are read from the weight value holding unit 43d.

The $h_i$ calculation unit 43e includes multipliers 43e1 and 43e2 and an $h_i$ update holding unit 43e3.

The $h_k$ calculation unit 43f includes a multiplier 43f1 and an $h_k$ update holding unit 43f2.

The multiplier 43e1 outputs a product of $\Delta x_j$ and the N $W_{ij}$'s.

The multiplier 43e2 outputs a product of $\Delta x_k$ and the N $W_{ki}$'s.

The multiplier 43f1 outputs a product of $\Delta x_j$ and the M $W_{kj}$'s.

The $h_i$ update holding unit 43e3 holds N $h_i$'s. Then, in a case where it is determined that flip is permissible for $x_j$, the $h_i$ update holding unit 43e3 updates $h_i$ by adding $\Delta h_i = W_{ij}\Delta x_j$ to each of the N $h_i$'s. Furthermore, in a case where it is determined that flip is permissible for $x_k$, the $h_i$ update holding unit 43e3 updates $h_i$ by adding $\Delta h_i = -\lambda_k W_{ki}\Delta x_k$ to each of the N $h_i$'s.

The $h_k$ update holding unit 43f2 holds M $h_k$'s. Then, in a case where it is determined that flip is permissible for $x_j$, the $h_k$ update holding unit 43f2 updates $h_k$ by adding $\Delta h_k = W_{kj}\Delta x_j$ to each of the M $h_k$'s.

Hereinafter, two examples of a processing procedure (data processing method) of the data processing apparatus 30 will be described.

FIG. 8 is a flowchart illustrating a flow of a first example of the data processing method.

Step S30: The input unit 41 receives input of initial values of N state variables, initial values of M auxiliary variables, problem information, and calculation conditions. The initial values of the N state variables are held in the state variable holding unit 43b, and the initial values of the M auxiliary variables are held in the auxiliary variable holding unit 43c. Furthermore, a weight value included in the problem information is held in the weight value holding unit 43d. The calculation conditions are supplied to the control unit 42.

Step S31: The control unit 42 performs initialization processing. In the initialization processing, for example, the following processing is performed.

The control unit 42 calculates an initial value of $h_i$ indicated in Expression (11) and an initial value of $h_k$ indicated in Expression (12) based on the initial values of the N state variables, the initial values of the M auxiliary variables, and the problem information. The calculated initial values of the N state variables are held in the $h_i$ update holding unit 43e3 illustrated in FIG. 7, and the calculated initial values of the M auxiliary variables are held in the $h_k$ update holding unit 43f2 illustrated in FIG. 7.

Furthermore, for example, the control unit 42 calculates an initial value of H(x) indicated in Expression (3) based on the initial values of the N state variables, the initial values of the M auxiliary variables, and the problem information. The calculated initial value of H(x) is held in, for example, the update unit 43l.

Moreover, in the initialization processing, an order of selecting state variables of flip candidates, an order of selecting auxiliary variables of flip candidates, the number of times of processing A of flip determination processing for the state variables, and the number of times of processing B of flip determination processing for the auxiliary variables are set in the variable setting unit 43a.

Step S32: The control unit 42 sets r1 = 0.

Step S33: A state variable ($x_i$) of a flip candidate is selected according to the processing order (which may be random) set in the variable setting unit 43a. When the state variable of the flip candidate is selected, a change amount ($\Delta x_i$) when a value of the state variable is changed is output from the state variable holding unit 43b.

Step S34: The $\Delta H$ calculation unit 43g of the search unit 43 calculates $\Delta H$ by an expression $\Delta H = -h_i \Delta x_i$.

Step S35: The transition propriety determination unit 43i of the search unit 43 performs flip determination for $x_i$ based on a result of comparison between $\Delta H$ and the predetermined value described above. In a case where it is determined that a change in $x_i$ is permitted (in a case where "flip is permissible"), processing of Step S36 is performed, and in a case where it is determined that a change in $x_i$ is not permitted (in a case where "flip is not permissible"), processing of Step S37 is performed.

Step S36: The search unit 43 updates $h_i$, $h_k$, H(x), and $x_i$ by the processing described above.

Step S37: The control unit 42 determines whether or not the processing satisfies a predetermined end condition. For example, the control unit 42 determines that the end condition is satisfied in a case where the number of times the search unit 43 has performed the flip determination processing reaches the maximum number of times of flip determination, or in a case where H(x) becomes equal to or smaller than predetermined magnitude. In a case where it is determined that the processing satisfies the predetermined end condition, processing of Step S48 is performed, and in a case where it is determined that the processing does not satisfy the predetermined end condition, processing of Step S38 is performed.

Step S38: The control unit 42 determines whether or not r1 = A holds. In a case where it is determined that r1 = A holds, processing of Step S40 is performed, and in a case where it is determined that r1 = A does not hold, processing of Step S39 is performed.

Step S39: The control unit 42 sets r1 = r1 + 1. Thereafter, the processing from Step S33 is repeated.

Step S40: The control unit 42 sets r2 = 0.

Step S41: An auxiliary variable ($x_k$) of a flip candidate is selected according to the processing order (which may be random) set in the variable setting unit 43a. When the auxiliary variable of the flip candidate is selected, a change amount ($\Delta x_k$) when a value of the auxiliary variable is changed is output from the auxiliary variable holding unit 43c.

Step S42: The $\Delta H$ calculation unit 43h of the search unit 43 calculates $\Delta H$ by an expression $\Delta H = +\lambda_k h_k \Delta x_k$.

Step S43: The transition propriety determination unit 43j of the search unit 43 performs flip determination for $x_k$ based on a result of comparison between $\Delta H$ and the predetermined value described above, for example. In a case where it is determined that a change in $x_k$ is permitted (in a case where "flip is permissible"), processing of Step S44 is performed, and in a case where it is determined that a change in $x_k$ is not permitted (in a case where "flip is not permissible"), processing of Step S45 is performed.

Step S44: The search unit 43 updates $h_i$, H(x), and $x_k$ by the processing described above.

Step S45: The control unit 42 determines whether or not the processing satisfies the predetermined end condition described above. In a case where it is determined that the processing satisfies the predetermined end condition, the processing of Step S48 is performed, and in a case where it is determined that the processing does not satisfy the predetermined end condition, processing of Step S46 is performed.

Step S46: The control unit 42 determines whether or not r2 = B holds. In a case where it is determined that r2 = B holds, the processing from Step S32 is repeated, and in a case where it is determined that r2 = B does not hold, processing of Step S47 is performed.

Step S47: The control unit 42 sets r2 = r2 + 1. Thereafter, the processing from Step S41 is repeated.

Step S48: The output unit 44 outputs a calculation result. With this configuration, the processing ends. For example, the output unit 44 may output the calculation result to the display 34a to be displayed, transmit the calculation result to another information processing device via the network 37a, or store the calculation result in an external storage device.

Note that, in a case where the simulated annealing method is performed, for example, the control unit 42 reduces the value of the temperature parameter (T) described above according to a predetermined temperature parameter change schedule each time when the flip determination processing for the state variable is repeated a predetermined number of times. Then, under the control of the control unit 42, the output unit 44 outputs a state obtained in a case where the flip determination processing is repeated the predetermined number of times as a calculation result of a discrete optimization problem. Note that the update unit 43l may hold total energy and a state in a case where the energy becomes the minimum until then. In that case, the control unit 42 may cause the output unit 44 to output a state corresponding to the minimum energy held after the flip determination processing is repeated the predetermined number of times as the calculation result.

In a case where the replica exchange method is performed, the processing of Steps S32 to S47 described above is repeated for each of a plurality of replicas to each of which a different T value is set. Then, the control unit 42 exchanges the replica each time when the flip determination processing is repeated a predetermined number of times. For example, the control unit 42 selects two replicas having adjacent T values and exchanges the T values or the values of the respective state variables and the values of the respective auxiliary variables between the selected two replicas at a predetermined exchange probability based on an energy difference or a T value difference between the replicas. For example, the update unit 43l holds total energy and a state in a case where the energy becomes the minimum until then. Then, the control unit 42 causes the output unit 44 to output, as a calculation result, a state corresponding to the minimum energy in all the replicas, among the minimum energy held after the flip determination processing described above is repeated the predetermined number of times in each replica.

According to the data processing method described above, in a case where the number of state variables affecting a constraint condition is relatively small, adjustment may be made to efficiently correct H(x) according to a discrete optimization problem to be calculated, such as increasing the number of times of processing A and decreasing the number of times of processing B.

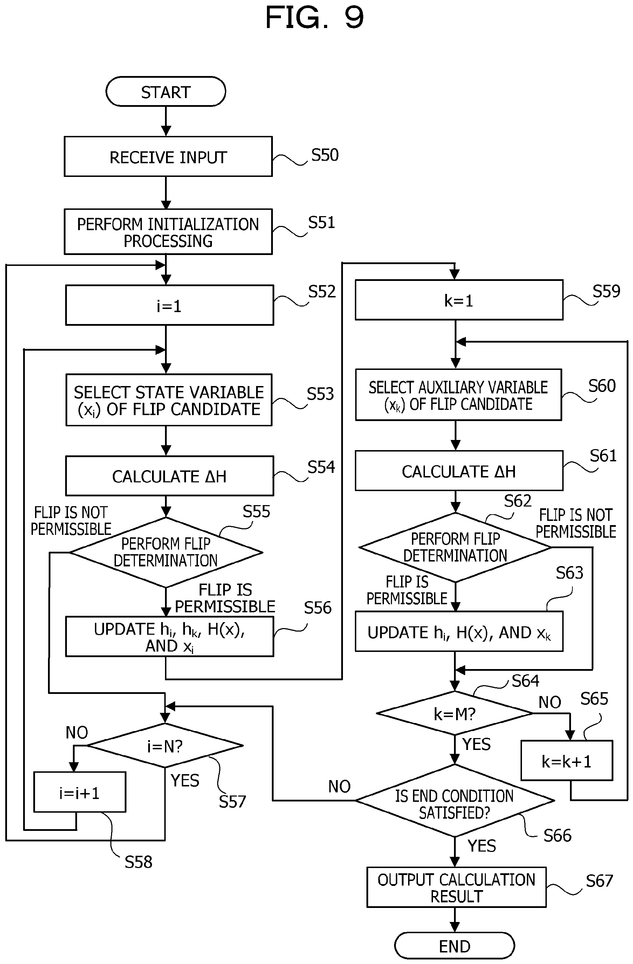

FIG. 9 is a flowchart illustrating a flow of a second example of the data processing method.

The processing of Steps S50 and S51 is almost the same as the processing of Steps S30 and S31 indicated in FIG. 8. However, in initialization processing of Step S51, setting of the number of times of processing A of flip determination processing for state variables and the number of times of processing B of flip determination processing for auxiliary variables is not performed.

Step S52: The control unit 42 sets i = 1. An identification number of a state variable corresponds to i.

Step S53: A state variable ($x_i$) of a flip candidate is selected. When the state variable of the flip candidate is selected, a change amount ($\Delta x_i$) when a value of the state variable is changed is output from the state variable holding unit 43b.

Step S54: The $\Delta H$ calculation unit 43g of the search unit 43 calculates $\Delta H$ by an expression $\Delta H = -h_i \Delta x_i$.

Step S55: The transition propriety determination unit 43i of the search unit 43 performs flip determination for $x_i$ based on a result of comparison between $\Delta H$ and the predetermined value described above. In a case where it is determined that a change in $x_i$ is permitted (in a case where "flip is permissible"), processing of Step S56 is performed, and in a case where it is determined that a change in $x_i$ is not permitted (in a case where "flip is not permissible"), processing of Step S57 is performed.

Step S56: The search unit 43 updates $h_i$, $h_k$, H(x), and $x_i$ by the processing described above.

Step S57: The control unit 42 determines whether or not i = N holds. In a case where it is determined that i = N holds, the processing from Step S52 is repeated, and in a case where it is determined that i = N does not hold, processing of Step S58 is performed.

Step S58: The control unit 42 sets i = i + 1. Thereafter, the processing from Step S53 is repeated.

Step S59: The control unit 42 sets k = 1.

Step S60: An auxiliary variable ($x_k$) of a flip candidate is selected. When the auxiliary variable of the flip candidate is selected, a change amount ($\Delta x_k$) when a value of the auxiliary variable is changed is output from the auxiliary variable holding unit 43c.

Step S61: The $\Delta H$ calculation unit 43h of the search unit 43 calculates $\Delta H$ by an expression $\Delta H = +\lambda_k h_k \Delta x_k$.

Step S62: The transition propriety determination unit 43j of the search unit 43 performs flip determination for $x_k$ based on a result of comparison between $\Delta H$ and the predetermined value described above, for example. In a case where it is determined that a change in $x_k$ is permitted (in a case where "flip is permissible"), processing of Step S63 is performed, and in a case where it is determined that a change in $x_k$ is not permitted (in a case where "flip is not permissible"), processing of Step S64 is performed.

Step S63: The search unit 43 updates $h_i$, H(x), and $x_k$ by the processing described above.

Step S64: The control unit 42 determines whether or not k = M holds. In a case where it is determined that k = M holds, processing of Step S66 is performed, and in a case where it is determined that k = M does not hold, processing of Step S65 is performed.

Step S65: The control unit 42 sets k = k + 1. Thereafter, the processing from Step S60 is repeated.

Step S66: The control unit 42 determines whether or not the processing satisfies a predetermined end condition. For example, the control unit 42 determines that the end condition is satisfied in a case where the number of times the search unit 43 has performed the flip determination processing reaches the maximum number of times of flip determination, or in a case where H(x) becomes equal to or smaller than predetermined magnitude. In a case where it is determined that the processing satisfies the predetermined end condition, the processing of Step S67 is performed, and in a case where it is determined that the processing does not satisfy the predetermined end condition, the processing from Step S57 is repeated.

Step S67: The output unit 44 outputs a calculation result. With this configuration, the processing ends. For example, the output unit 44 may output the calculation result to the display 34a to be displayed, transmit the calculation result to another information processing device via the network 37a, or store the calculation result in an external storage device.

According to the data processing method described above, each time it is determined that a change in a value of a state variable is permitted, flip determination is made for the M auxiliary variables, so that in a case where the number of state variables affecting a constraint condition is relatively large, H(x) may be corrected efficiently.

Note that, as in the first example of the data processing method, the simulated annealing method and the replica exchange method may also be applied in the second example described above.

Furthermore, in the second example, it is assumed that the state variables and the auxiliary variables of the flip candidates are selected in the order of identification numbers, but they may be selected at random.

Note that the order of the processing illustrated in FIG. 8 and FIG. 9 is an example, and the order of the processing may be appropriately changed.

According to the data processing apparatus 30 and the data processing method of the second embodiment as described above, an effect similar to that of the data processing apparatus 10 and the data processing method of the first embodiment may be obtained. For example, overhead of a calculation time may be reduced. Furthermore, a data transfer amount may also be reduced.

For example, in the data processing apparatus 20 of the comparative example illustrated in FIG. 4 described above, the processing of Step S22 indicated in FIG. 4 is repeated M times to calculate $\Delta P_j$ for each of $x_1$ to $x_N$. For example, reading of $W_{kj}$ and addition processing are performed M times. Thus, it takes a time proportional to $N \times M$ to calculate N $\Delta P_j$'s, and overhead of a calculation time is large. Furthermore, a data transfer amount for the reading is large. This is because the M $W_{kj}$'s are serially read in calculating one $\Delta P_j$.

On the other hand, in the data processing apparatus 30 of the second embodiment, since $h_i$ is updated by $\Delta h_i = -\lambda_k W_{ki} \Delta x_k$ for the auxiliary variable whose value is permitted to change among the M auxiliary variables, it is sufficient that the N $W_{ki}$'s are read once. With this configuration, overhead of the calculation time may be reduced, and the data transfer amount for reading $W_{ki}$ may also be reduced.

The update of $h_i$ is performed by processing of adding $\Delta h_i = W_{ij} \Delta x_j$ in a case where $x_j$ changes and processing of adding $\Delta h_i = -\lambda_k W_{ki} \Delta x_k$ in a case where $x_k$ changes. For example, overhead associated with updating $h_i$ in a case where the flip determination processing is performed once for the N state variables is at most caused by processing of adding $W_{ij} \Delta x_j$ N times and processing of adding $-\lambda_k W_{ki} \Delta x_k$ Mp times (p is a ratio at which $x_k$ changes). In this case, the overhead is proportional to N + Mp, which is smaller than that in the data processing apparatus 20 of the comparative example in which the overhead is proportional to $N \times M$. Note that, in a case where the sparse ratio η described above is smaller than 1, the overhead is proportional to N + ηMp, and the overhead may be further reduced.

Note that, as described above, the processing contents described above may be implemented by causing the data processing apparatus 30 to execute a program.

The program may be recorded in a computer-readable recording medium (for example, the recording medium 36a). As the recording medium, for example, a magnetic disk, an optical disk, a magneto-optical disk, a semiconductor memory, or the like may be used. The magnetic disk includes an FD and an HDD. The optical disk includes a CD, a CD-recordable (R)/rewritable (RW), a DVD, and a DVD-R/RW. The program may be recorded in a portable recording medium and distributed. In that case, the program may be copied from the portable recording medium to another recording medium (for example, the HDD 33) and then executed.

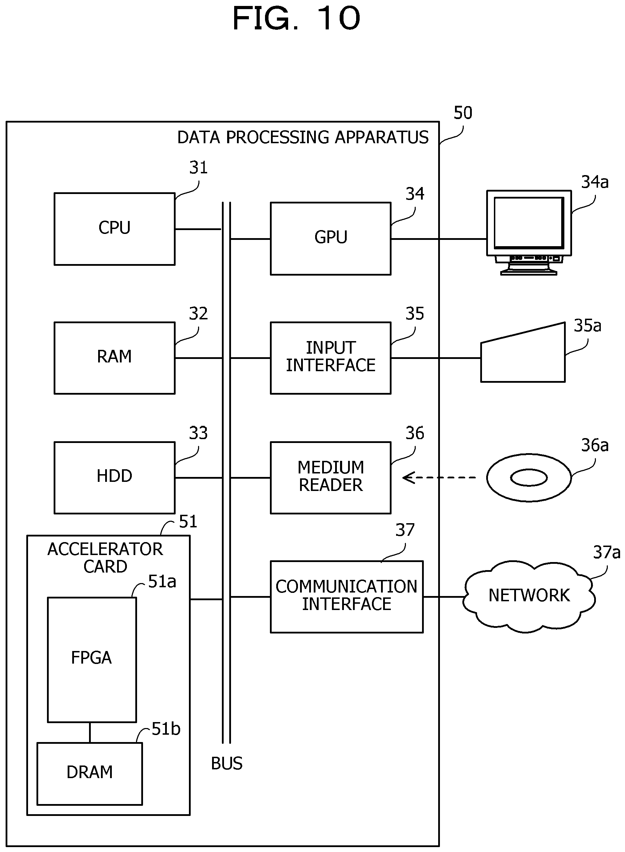

FIG. 10 is a diagram illustrating another example of the data processing apparatus. In FIG. 10, elements same as the elements illustrated in FIG. 5 are denoted by the same reference signs.

A data processing apparatus 50 includes an accelerator card 51 connected to a bus.

The accelerator card 51 is a hardware accelerator that searches for a solution to a discrete optimization problem. The accelerator card 51 includes an FPGA 51a and a DRAM 51b.

In the data processing apparatus 50, the FPGA 51a performs, for example, the processing of the control unit 42 and the search unit 43 illustrated in FIG. 6.

Furthermore, the DRAM 51b functions as, for example, the weight value holding unit 43d illustrated in FIG. 6.

Note that there may be a plurality of the accelerator cards 51.

In the above, one aspect of the data processing apparatus, the program, and the data processing method according to the embodiments has been described based on the embodiments. However, these are merely examples, and are not limited to the description above.

Although the case where the inequality constraint is mainly used as the constraint condition has been described above, another constraint condition such as the equality constraint may also be used.

For example, in a case where the equality constraint is used, the following Expression (13) is used instead of Expression (9) for the total energy (H(x)).

[Expression 13]

$$H(x) = E(x) + (x) \qquad (13)$$
$$= E(x) + \sum_{i \in D, k \in A} \lambda_k |R_k(x) - U_k|$$
$$= E(x) + \sum_{i \in D, k \in A} \lambda_k x_k$$

Here, a spin variable having a value of -1 or +1 may be used as the auxiliary variable ($x_k$). In that case, it may be represented as $\Delta x_k = -2x_k$. In a case where the equality constraint is not satisfied ($R_k(x) \neq U_k$), $x_k$ becomes -1, and in a case where the equality constraint is satisfied ($R_k(x) = U_k$), $x_k$ becomes +1.

In a case where such an auxiliary variable is used, $\Delta H$ may be represented as $\Delta H = +\lambda_k h_k \Delta x_k$ as in the case described above.

Note that, in a case where a binary variable is used instead of the spin variable, it is sufficient to set $\Delta H = +2\lambda_k h_k \Delta x_k$ instead of $\Delta H = +\lambda_k h_k \Delta x_k$.

Furthermore, the auxiliary variable may have values of equal to or greater than three values.

FIG. 11 is a diagram illustrating an example using four values of auxiliary variables. A vertical axis represents magnitude of the constraint term with the identification number k, and a horizontal axis represents $h_k$.

$x_k$ has four values 0, 1, 2, and 3. A state where a constraint condition is satisfied is indicated by $x_k = 0$, and three constraint condition violated states are indicated by $x_k = 1$, 2, and 3. In the example of FIG. 11, a constraint violated state from ($h_1$, $g_1$) to ($h_2$, $g_2$), a constraint violated state from ($h_2$, $g_2$) to ($h_3$, $g_3$), and a constraint violated state equal to or greater than ($h_3$, $g_3$) are indicated.

Furthermore, as $\lambda_k$ described above, $\lambda_1$ is used in a case where $x_k = 1$, $\lambda_2$ is used in a case where $x_k = 2$, and $\lambda_3$ is used in a case where $x_k = 3$. With this configuration, a constraint term that increases with different slopes as $h_k$ increases may be used, depending on whether $x_k = 1$, 2, or 3.

In a case where the auxiliary variable as described above is used, $\Delta H_{i \rightarrow j}$ in the case of changing from ($h_i$, $g_i$) to ($h_j$, $g_j$) may be represented as $\Delta H_{i \rightarrow j} = [\lambda_j(h_k - h_j) + g_j] - [\lambda_i(h_k - h_i) + g_i] = (\lambda_j - \lambda_i)h_k + [(g_j - \lambda_j h_j) - (g_i - \lambda_i h_i)]$.

**Claims**

1. A data processing apparatus that searches for a combination of values of a plurality of state variables that minimizes or maximizes a value of an Ising-type evaluation function that includes the plurality of state variables, the data processing apparatus comprising:

   a storage unit that store total energy that is a sum of values of a plurality of constraint terms and the value of the evaluation function, the values of the plurality of state variables, values of a plurality of auxiliary variables, a first weight value between each of the plurality of state variables, a second weight value between one of the plurality of state variables and each of the plurality of auxiliary variables, a first local field, and a second local field, the plurality of constraint terms including values that correspond to whether each of a plurality of constraint conditions is violated, plurality of auxiliary variables indicating whether each of the plurality of constraint conditions is violated, the first local field indicating a change amount of the total energy when a value of each of the plurality of state variables changes, the second local field being a value proportional to a change amount of the total energy when a value of each of the plurality of auxiliary variables changes;
   a processing unit that:

performs first processing that includes:

determining whether to permit a change in a value of a first state variable among the plurality of state variables based on the first local field, and
when the change in the value of the first state variable is permitted, updating the value of the first state variable, updating the first local field based on the first weight value related to the first state variable, and updating the second local field based on the second weight value related to the first state variable, and

performs second processing that includes:

determining whether to permit a change in a value of a first auxiliary variable among the plurality of auxiliary variables based on the second local field, and
when the change in the value of the first auxiliary variable is permitted, updating the value of the first auxiliary variable, and updating the first local field based on the second weight value related to the first auxiliary variable.

2. The data processing apparatus according to claim 1, wherein the processing unit is further configured to:

when a violation of a first constraint condition among the plurality of constraint conditions occurs due to the change in the value of the first state variable, permit the value of the first auxiliary variable that corresponds to the first constraint condition to be changed to a value that represents that there is a violation, and
correct the total energy according to the permitting.

3. The data processing apparatus according to claim 1, wherein the processing unit is further configured to:

when a violation of a first constraint condition among the plurality of constraint conditions is resolved due to the change in the value of the first state variable, permit the value of the first auxiliary variable that corresponds to the first constraint condition to be changed to a value that represents that there is no violation, and
correct the total energy according to the permitting.

4. The data processing apparatus according to any one of claims 1 to 3, wherein the processing unit is further configured to
repeat the performing the second processing a second number of times after the first processing is performed a first number of times.

5. The data processing apparatus according to any one of claims 1 to 3, wherein the processing unit is further configured to
perform the second processing a number of times that corresponds to the number of the plurality of auxiliary variables each time the first processing that the change in the value of the first state variable is permitted.

6. A data processing program that causes at least one computer to execute a process, the process comprising:

searching for a combination of values of a plurality of state variables that minimizes or maximizes a value of an Ising-type evaluation function that includes the plurality of state variables;
storing total energy that is a sum of values of a plurality of constraint terms and the value of the evaluation function, the values of the plurality of state variables, values of a plurality of auxiliary variables, a first weight value between each of the plurality of state variables, a second weight value between one of the plurality of state variables and each of the plurality of auxiliary variables, a first local field, and a second local field, the plurality of constraint terms including values that correspond to whether each of a plurality of constraint conditions is violated, plurality of auxiliary variables indicating whether each of the plurality of constraint conditions is violated, the first local field indicating a change amount of the total energy when a value of each of the plurality of state variables changes, the second local field being a value proportional to a change amount of the total energy when a value of each of the plurality of auxiliary variables changes;
performing first processing that includes:

determining whether to permit a change in a value of a first state variable among the plurality of state variables based on the first local field, and

when the change in the value of the first state variable is permitted, updating the value of the first state variable, updating the first local field based on the first weight value related to the first state variable, and updating the second local field based on the second weight value related to the first state variable; and

performing second processing that includes:

determining whether to permit a change in a value of a first auxiliary variable among the plurality of auxiliary variables based on the second local field, and
when the change in the value of the first auxiliary variable is permitted, updating the value of the first auxiliary variable, and updating the first local field based on the second weight value related to the first auxiliary variable.

7. The data processing program according to claim 6, wherein the process further comprising:

when a violation of a first constraint condition among the plurality of constraint conditions occurs due to the change in the value of the first state variable, permitting the value of the first auxiliary variable that corresponds to the first constraint condition to be changed to a value that represents that there is a violation, and correcting the total energy according to the permitting.

8. The data processing program according to claim 6, wherein the process further comprising:

when a violation of a first constraint condition among the plurality of constraint conditions is resolved due to the change in the value of the first state variable, permitting the value of the first auxiliary variable that corresponds to the first constraint condition to be changed to a value that represents that there is no violation, and correcting the total energy according to the permitting.

9. The data processing program according to any one of claims 6 to 8, wherein the process further comprising repeating the performing the second processing a second number of times after the first processing is performed a first number of times.

10. The data processing program according to any one of claims 6 to 8, wherein the process further comprising performing the second processing a number of times that corresponds to the number of the plurality of auxiliary variables each time the first processing that the change in the value of the first state variable is permitted.

11. A data processing method for a computer to execute a process comprising:

searching for a combination of values of a plurality of state variables that minimizes or maximizes a value of an Ising-type evaluation function that includes the plurality of state variables;
storing total energy that is a sum of values of a plurality of constraint terms and the value of the evaluation function, the values of the plurality of state variables, values of a plurality of auxiliary variables, a first weight value between each of the plurality of state variables, a second weight value between one of the plurality of state variables and each of the plurality of auxiliary variables, a first local field, and a second local field, the plurality of constraint terms including values that correspond to whether each of a plurality of constraint conditions is violated, plurality of auxiliary variables indicating whether each of the plurality of constraint conditions is violated, the first local field indicating a change amount of the total energy when a value of each of the plurality of state variables changes, the second local field being a value proportional to a change amount of the total energy when a value of each of the plurality of auxiliary variables changes;
performing first processing that includes:

determining whether to permit a change in a value of a first state variable among the plurality of state variables based on the first local field, and
when the change in the value of the first state variable is permitted, updating the value of the first state variable, updating the first local field based on the first weight value related to the first state variable, and updating the second local field based on the second weight value related to the first state variable; and

performing second processing that includes:

determining whether to permit a change in a value of a first auxiliary variable among the plurality of auxiliary variables based on the second local field, and

when the change in the value of the first auxiliary variable is permitted, updating the value of the first auxiliary variable, and updating the first local field based on the second weight value related to the first auxiliary variable.

12. The data processing method according to claim 11, wherein the process further comprising:

when a violation of a first constraint condition among the plurality of constraint conditions occurs due to the change in the value of the first state variable, permitting the value of the first auxiliary variable that corresponds to the first constraint condition to be changed to a value that represents that there is a violation, and correcting the total energy according to the permitting.

13. The data processing method according to claim 11, wherein the process further comprising:

when a violation of a first constraint condition among the plurality of constraint conditions is resolved due to the change in the value of the first state variable, permitting the value of the first auxiliary variable that corresponds to the first constraint condition to be changed to a value that represents that there is no violation, and correcting the total energy according to the permitting.

14. The data processing method according to any one of claims 11 to 13, wherein the process further comprising repeating the performing the second processing a second number of times after the first processing is performed a first number of times.

15. The data processing method according to any one of claims 11 to 13, wherein the process further comprising performing the second processing a number of times that corresponds to the number of the plurality of auxiliary variables each time the first processing that the change in the value of the first state variable is permitted.

# FIG. 1

STATE VARIABLE (DECISION VARIABLE) $x_i$ ($i \in D$)

AUXILIARY VARIABLE $x_k$ ($k \in A$)

CONSTRAINT CONDITION VIOLATION
PRESENT: $x_k = 1$
ABSENT: $x_k = 0$

| SELECT STATE VARIABLE OF FLIP CANDIDATE | S1 |
| CALCULATE ΔH | S2 |
| PERFORM FLIP DETERMINATION | S3 |
| UPDATE $h_i$, $h_k$, $H(x)$, AND $x_i$ | S4 |

S5 HAS PROCESSING ENDED A TIMES?
NO    YES

| SELECT AUXILIARY VARIABLE OF FLIP CANDIDATE | S6 |
| CALCULATE ΔH | S7 |
| PERFORM FLIP DETERMINATION | S8 |
| UPDATE $h_i$, $H(x)$, AND $x_k$ | S9 |

S10 HAS PROCESSING ENDED B TIMES?
NO    YES

10 DATA PROCESSING APPARATUS

12 PROCESSING UNIT

11 STORAGE UNIT

TOTAL ENERGY $H(x)$

STATE VARIABLE $x_i$ (DECISION VARIABLE)

AUXILIARY VARIABLE $x_k$

FIRST WEIGHT VALUE $W_{ij}$

SECOND WEIGHT VALUE $W_{ki}$

FIRST LOCAL FIELD $h_i$

SECOND LOCAL FIELD $h_k$

# FIG. 2

STATE VARIABLE
(DECISION VARIABLE)
$x_i$ (i∈N)

AUXILIARY
VARIABLE
$x_k$ (k∈M)

# FIG. 3

CONSTRAINT TERM

$\lambda_k \max[0, R_k(x) - U_k]$

$x_k = 1$

$U_k$

B

D

0 $R_k(x)$

A

$x_k = 0$

C

$\lambda_k h_k \Delta x_k$

# FIG. 4

EP 4 254 271 A1

# FIG. 5

DATA PROCESSING APPARATUS — 30

31 — CPU

34 — GPU — 34a

32 — RAM

35 — INPUT INTERFACE — 35a

33 — HDD

36 — MEDIUM READER — 36a

37 — COMMUNICATION INTERFACE — 37a NETWORK

BUS

# FIG. 6

```
                                                                    30
                                                        DATA PROCESSING APPARATUS

        41                       42                              44
┌─────────────────┐      ┌─────────────────┐          ┌─────────────────┐
│   INPUT UNIT    │◄────►│  CONTROL UNIT   │◄────────►│  OUTPUT UNIT    │
└─────────────────┘      └─────────────────┘          └─────────────────┘
```

# FIG. 7

# FIG. 8

START

RECEIVE INPUT — S30

PERFORM INITIALIZATION PROCESSING (SET THE NUMBERS OF TIMES OF PROCESSING A AND B) — S31

r1=0 — S32

SELECT STATE VARIABLE ($x_i$) OF FLIP CANDIDATE — S33

CALCULATE ΔH — S34

S35 PERFORM FLIP DETERMINATION — FLIP IS NOT PERMISSIBLE

FLIP IS PERMISSIBLE

UPDATE $h_i$, $h_k$, H(x), AND $x_i$ — S36

IS END CONDITION SATISFIED? — S37

NO — r1=r1+1 — S39

NO

r1=A? — S38 — YES

YES

r2=0 — S40

SELECT AUXILIARY VARIABLE ($x_k$) OF FLIP CANDIDATE — S41

CALCULATE ΔH — S42

S43 PERFORM FLIP DETERMINATION — FLIP IS NOT PERMISSIBLE

FLIP IS PERMISSIBLE

UPDATE $h_i$, H(x), AND $x_k$ — S44

IS END CONDITION SATISFIED? — S45

NO — r2=r2+1 — S47

NO

r2=B? — S46 — YES

YES

OUTPUT CALCULATION RESULT — S48

END

# FIG. 9

START

RECEIVE INPUT — S50

PERFORM INITIALIZATION PROCESSING — S51

i=1 — S52

k=1 — S59

SELECT STATE VARIABLE ($x_i$) OF FLIP CANDIDATE — S53

SELECT AUXILIARY VARIABLE ($x_k$) OF FLIP CANDIDATE — S60

CALCULATE ΔH — S54

CALCULATE ΔH — S61

FLIP IS NOT PERMISSIBLE

PERFORM FLIP DETERMINATION — S55

FLIP IS PERMISSIBLE

UPDATE $h_i$, $h_k$, H(x), AND $x_i$ — S56

PERFORM FLIP DETERMINATION — S62

FLIP IS NOT PERMISSIBLE

FLIP IS PERMISSIBLE

UPDATE $h_i$, H(x), AND $x_k$ — S63

NO

i=N? — S57

YES

i=i+1 — S58

k=M? — S64

NO — S65

YES

k=k+1

NO

IS END CONDITION SATISFIED? — S66

YES

OUTPUT CALCULATION RESULT — S67

END

# FIG. 10

DATA PROCESSING APPARATUS 50

31

CPU

32

RAM

33

HDD

51

ACCELERATOR
CARD

51a

FPGA

51b

DRAM

BUS

34

GPU

34a

35

INPUT
INTERFACE

35a

36

MEDIUM
READER

36a

37

COMMUNICATION
INTERFACE

NETWORK 37a

# FIG. 11

CONSTRAINT
TERM

$(h_3, g_3)$

$(h_2, g_2)$

$(h_1, g_1)$

$h_k$

AUXILIARY VARIABLE 0 1 2 3

COEFFICIENT $\lambda_k$ $\lambda_1$ $\lambda_2$ $\lambda_3$

Europäisches
Patentamt

European
Patent Office

Office européen
des brevets

# EUROPEAN SEARCH REPORT

**Application Number**

EP 22 21 6933

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/050709 A1 (TOMITA YOSHINORI [JP]) 17 February 2022 (2022-02-17) * paragraphs [0004] – [0009], [0140] – [0145]; figures 1,2,3 * ----- | 1–15 | INV. G06N3/044 G06N5/01 |
| X | EP 3 757 908 A1 (FUJITSU LTD [JP]) 30 December 2020 (2020-12-30) * paragraphs [0004] – [0009], [0016] – [0025]; figures 1,3,4,5,10 * ----- | 1–15 | |

**TECHNICAL FIELDS SEARCHED (IPC)**

G06N

The present search report has been drawn up for all claims

| Place of search | Date of completion of the search | Examiner |
|---|---|---|
| The Hague | 11 August 2023 | Manfrin, Max |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 6933

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2023

| Patent document cited in search report | | Publication date | Patent family member(s) | | Publication date |
|---|---|---|---|---|---|
| US 2022050709 | A1 | 17-02-2022 | CN | 114118506 A | 01-03-2022 |
| | | | EP | 3955139 A1 | 16-02-2022 |
| | | | JP | 2022032552 A | 25-02-2022 |
| | | | US | 2022050709 A1 | 17-02-2022 |
| EP 3757908 | A1 | 30-12-2020 | CN | 112100799 A | 18-12-2020 |
| | | | EP | 3757908 A1 | 30-12-2020 |
| | | | JP | 7323777 B2 | 09-08-2023 |
| | | | JP | 2020204928 A | 24-12-2020 |
| | | | US | 2020401651 A1 | 24-12-2020 |

EPO FORM P0459

For more details about this annex : see Official Journal of the European Patent Office, No. 12/82

**EP 4 254 271 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2020201598 A
- JP 2020204928 A